(19) Europäisches Patentamt / European Patent Office / Office européen des brevets

(11) **EP 1 930 386 A2**

(12) **EUROPEAN PATENT APPLICATION**

(43) Date of publication:
**11.06.2008 Bulletin 2008/24**

(51) Int Cl.:
*C09J 7/02* (2006.01)　　　*C09J 133/06* (2006.01)

(21) Application number: **07023582.5**

(22) Date of filing: **05.12.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **06.12.2006 JP 2006328928**

(71) Applicant: **NITTO DENKO CORPORATION**
**Osaka (JP)**

(72) Inventors:
• **Sasaki, Takatoshi**
**Iberaki-shi**
**Osaka (JP)**

• **Asai, Fumiteru**
**Iberaki-shi**
**Osaka (JP)**
• **Shintani, Toshio**
**Iberaki-shi**
**Osaka (JP)**
• **Takahashi, Tomokazu**
**Iberaki-shi**
**Osaka (JP)**

(74) Representative: **Grünecker, Kinkeldey,**
**Stockmair & Schwanhäusser**
**Anwaltssozietät**
**Leopoldstrasse 4**
**80802 München (DE)**

(54) **Removable pressure-sensitive adhesive composition and pressure-sensitive adhesive tape or sheet**

(57) The present invention relates to a removable pressure-sensitive adhesive composition containing an acrylic polymer, a photopolymerization initiator and a crosslinking agent, in which the acrylic polymer and the photopolymerization initiator each are chemically bonded to the crosslinking agent. The present invention also relates to a removable pressure-sensitive adhesive composition containing an acrylic polymer and a photopolymerization initiator, the composition further containing a crosslinking agent having a reactive functional group which is capable of reacting with a reactive functional group of the acrylic polymer and a reactive functional group of the photopolymerization initiator.

EP 1 930 386 A2

**Description**

**FIELD OF THE INVENTION**

The present invention relates to a pressure-sensitive adhesive composition and a pressure-sensitive adhesive tape or sheet using the same. More particularly, the invention relates to a pressure-sensitive adhesive tape or sheet for dicing, which is used, when a semiconductor wafer or the like is cut (diced) to device chips, for fixing a material to be diced such as the semiconductor wafer; and to a pickup pressure-sensitive adhesive tape or sheet used for individually separating (picking up) the material to be diced which has been diced.

**BACKGROUND OF THE INVENTION**

Conventionally, a semiconductor wafer made of a material such as silicon, germanium or gallium-arsenic is generally produced in a large-diameter form, thereafter subjected to back grinding so as to result in a given thickness, and further subjected to back-side processing (such as etching processing or polishing processing) as needed. Then, a pressure-sensitive adhesive tape or sheet for dicing (the term "tape or sheet" is hereinafter sometimes simply referred to as "tape" or "sheet") is attached to the back side of the semiconductor wafer, and thereafter, the wafer is separately cut (diced) into device chips. Subsequently, various steps such as a cleaning step, an expanding step, a pickup step and a mounting step are performed.

In order to separate the semiconductor wafer made of the material such as silicon or gallium-arsenic to wafer chips, the semiconductor wafer is previously attached and fixed to the pressure-sensitive adhesive sheet, and thereafter, dicing, cleaning, drying, expanding, pickup and mounting are performed. However, in these steps, the elimination and scattering of the wafer chips from the pressure-sensitive adhesive sheet occurs. Further, although adhesion strength can be easily increased in order to inhibit the elimination and scattering of the wafer chips, since it becomes difficult to peel the wafer chips from the pressure-sensitive adhesive sheet at the time of pickup, pickup has recently become difficult as the integration degree increases to enlarge the area of the wafer chips. In order to solve these problems, there is used an ultraviolet-light-curable pressure-sensitive adhesive sheet for fixing a semiconductor wafer, which is obtained by applying a pressure-sensitive adhesive composition curable through crosslinking with ultraviolet light irradiation to a substrate having an ultraviolet-light-permeable surface to thereby form a pressure-sensitive adhesive layer having the performance of decreasing adhesion strength. According to this pressure-sensitive adhesive sheet, strong adhesion strength can be kept in the dicing, cleaning and drying steps, and thereafter, adhesion strength can be decreased by curing the ultraviolet-light-curable pressure-sensitive adhesive layer through crosslinking with ultraviolet light irradiation from the support side, thereby being able to easily perform the pickup of the wafer chips.

As the substrates of these ultraviolet-light-curable pressure-sensitive adhesive sheets, there have been used films of polyvinyl chloride and a copolymer thereof, and polyolefin films such as polyethylene, polypropylene, polybutene and an ethylene-vinyl acetate copolymer. Especially, polyvinyl chloride-based films have been commonly used. The polyvinyl chloride-based film provides sufficient distance between chip elements in the expanding step in which the pressure-sensitive adhesive sheet is stretched, in comparison with the polyolefin-based film.

However, in such an ultraviolet-light-curable pressure-sensitive adhesive sheet for fixing a semiconductor wafer, in which the pressure-sensitive adhesive layer having the performance of decreasing adhesion strength by curing through crosslinking with ultraviolet light irradiation is formed on the substrate, there occurs the problem that a low molecular weight ingredient (photopolymerization initiator) contained in the pressure-sensitive adhesive layer migrates to the substrate side to thereby decrease reactivity of an ultraviolet-light-curable compound, which causes no occurrence of smooth curing through crosslinking, resulting in a decrease in adhesion strength of the pressure-sensitive adhesive sheet. As a result, the wafer chips are eliminated and scattered in the wafer chip production step, particularly in the dicing and cleaning steps, which causes a decrease in yield.

In order to solve such a problem, a method of providing a migration-prevention layer for preventing migration of a plasticizer at the interface between polyvinyl chloride or the copolymer thereof and the ultraviolet-light-curable pressure-sensitive adhesive layer has been reported. However, it is difficult to completely block the migration of the low molecular weight ingredient (see JP-A-11-263946 and JP-A-2000-281991).

**SUMMARY OF THE INVENTION**

Accordingly, an object of the invention is to provide a removable pressure-sensitive adhesive composition which can exhibit the characteristic of being easily removable from an adherend by preventing migration of a photopolymerization initiator which is a low molecular weight ingredient and decreasing adhesion strength by irradiation of an active energy ray in a pressure-sensitive adhesive layer formed.

Another object of the invention is to provide a removable pressure-sensitive adhesive composition used for the formation of a pressure-sensitive adhesive layer of a pressure-sensitive adhesive sheet.

Still another object of the invention is to provide a pressure-sensitive adhesive sheet for dicing.

In order to solve the above-mentioned problems, the present inventors have made intensive studies. As a result, it has been found that the use of a specific removable pressure-sensitive adhesive composition enables preventing migration of a photopolymerization initiator which is a low molecular weight ingredient as well as decreasing adhesion strength by irradiation of an active energy ray, in a pressure-sensitive adhesive layer formed, whereby the pressure-sensitive adhesive layer can exhibit the characteristic of being easily removable from an adherend. Thus, the invention has been completed.

## BRIEF DESCRIPTION OF THE DRAWINGS

Fig. 1 is a schematic sectional view showing one embodiment of a pressure-sensitive adhesive tape or sheet of the invention.

Fig. 2 is a schematic sectional view showing a method for measuring adhesion strength of a tape or sheet.

Description of Reference Numerals and Signs

1: Pressure-Sensitive Adhesive Tape or Sheet

11: Substrate

12: Removable Pressure-Sensitive Adhesive Layer

13: Separator

14: Silicon Mirror Wafer

θ: Amble (Peel Angle) between Surface of Removable Pressure-Sensitive Adhesive Layer 12 and Surface of Silicon Mirror Wafer 14

a: Direction (Pulling Direction) in Which Pressure-Sensitive Adhesive Tape or Sheet 1 Is Peeled

## DETAILED DESCRIPTION OF THE INVENTION

Namely, the invention provides a removable pressure-sensitive adhesive composition comprising an acrylic polymer, a photopolymerization initiator and a crosslinking agent, wherein the acrylic polymer and the photopolymerization initiator each are chemically bonded to the crosslinking agent.

Furthermore, the invention also provides a removable pressure-sensitive adhesive composition comprising an acrylic polymer and a photopolymerization initiator, the composition further comprising a crosslinking agent having a reactive functional group which is capable of reacting with a reactive functional group of the acrylic polymer and a reactive functional group of the photopolymerization initiator.

It is preferred that the acrylic polymer contained in the removable pressure-sensitive adhesive composition has one carbon-carbon double bond in each of 1/100 or more of all side chains within the molecule thereof. Furthermore, the acrylic polymer contained in the removable pressure-sensitive adhesive composition preferably has a weight average molecular weight of 500,000 or more.

The chemical bond between the acrylic polymer and the crosslinking agent and that between the photopolymerization initiator and the crosslinking agent in the removable pressure-sensitive adhesive composition each preferably are a chemical bond between an isocyanate group and a hydroxyl group.

It is preferred that the removable pressure-sensitive adhesive composition further comprises an active energy ray-curable ingredient as an essential ingredient.

Furthermore, the invention provides a pressure-sensitive adhesive tape or sheet comprising a pressure-sensitive adhesive layer formed by the above-mentioned removable pressure-sensitive adhesive composition.

In the above-mentioned pressure-sensitive adhesive tape or sheet, the pressure-sensitive adhesive layer is preferably disposed on at least one side of a substrate. Furthermore, the substrate is preferably a soft polyvinyl chloride-based substrate.

The above-mentioned pressure-sensitive adhesive tape or sheet is preferably for use in dicing.

Since the removable pressure-sensitive adhesive composition of the invention has the above-mentioned constitution, it can exhibit the characteristic of being easily removable from an adherend by preventing migration of a photopolymerization initiator which is a low molecular weight ingredient and decreasing adhesion strength by irradiation of an active energy ray in a pressure-sensitive adhesive layer formed. Furthermore, the pressure-sensitive adhesive tape or sheet having the pressure-sensitive adhesive layer formed by the removable pressure-sensitive adhesive composition can be used for dicing.

Removable Pressure-Sensitive Adhesive Composition

The removable pressure-sensitive adhesive composition exhibits an excellent pressure-sensitive adhesiveness, when attached to an adherend (material to be processed), whereas it provides a pressure-sensitive adhesive surface exhibiting excellent releasability due to a decrease in adhesion strength by curing caused by an increase in the degree of crosslinking thereof through irradiation of an active energy ray, when separated from the adherend (material to be processed). Additionally, it further forms a pressure-sensitive adhesive layer which inhibits migration of a photopolymerization initiator which is a low molecular weight ingredient to make it possible to inhibit the defect that adhesion strength is not decreased even when the active energy ray is irradiated.

Further, since the pressure-sensitive adhesive layer (sometimes referred to as the "removable pressure-sensitive adhesive layer) formed by the removable pressure-sensitive adhesive composition exhibits the characteristics as described above, the removable pressure-sensitive adhesive composition is suitably used as a pressure-sensitive adhesive composition forming a pressure-sensitive adhesive layer of a pressure-sensitive adhesive sheet for dicing, which is required to exhibit an excellent pressure-sensitive adhesiveness to effectively prevent separation of chips in dicing when attached to the adherend (material to be processed), whereas required to exhibit an excellent releasability to effectively perform pickup of chips in picking up when separated from the adherend.

Examples of the active energy rays (radiations) include ionizing radiations such as α-rays, β-rays, γ-rays, neutron beams and electron beams, and ultraviolet light. Ultraviolet light is particularly preferred. The irradiation energy, irradiation time, irradiation method and the like of the active energy ray are not particularly limited, so long as a photopolymerization initiator is activated to allow polymerization or curing to occur.

It is important that such a removable pressure-sensitive adhesive composition is a composition containing an acrylic pressure-sensitive adhesive as a pressure-sensitive adhesive, a photopolymerization initiator and a crosslinking agent. That is to say, the removable pressure-sensitive adhesive composition is not particularly limited, so long as it contains at least an acrylic polymer as a base polymer in the acrylic pressure-sensitive adhesive, the photopolymerization initiator and the crosslinking agent as constituents. Examples thereof include (i) a composition containing the acrylic polymer, the photopolymerization initiator and the crosslinking agent as essential ingredients, in which the acrylic polymer and the photopolymerization initiator each are chemically bonded to the crosslinking agent; and (ii) a composition containing the acrylic polymer, the photopolymerization initiator and the crosslinking agent having a reactive functional group which is capable of reacting with a reactive functional group of the acrylic polymer and a reactive functional group of the photopolymerization initiator. The timing when the crosslinking agent contained in the removable pressure-sensitive adhesive composition is crosslinked with the acrylic polymer or the photopolymerization initiator is not particularly limited, so long as migration of the photopolymerization initiator can be prevented in the pressure-sensitive adhesive layer formed. Accordingly, the crosslinking agent may be crosslinked during the preparation of the pressure-sensitive adhesive composition, during the formation of the pressure-sensitive adhesive layer or after the formation of the pressure-sensitive adhesive layer.

The acrylic polymer contained in the removable pressure-sensitive adhesive composition as an essential ingredient is a polymer (homopolymer or copolymer) containing a (meth)acrylic ester as a main monomer ingredient. Examples of the (xneth)acrylic esters include alkyl (meth)acrylates such as methyl (meth)acrylate, ethyl (meth)acrylate, propyl (meth)acrylate, isopropyl (meth)acrylate, butyl (meth)acrylate, isobutyl (roeth)acrylate, s-butyl (meth)acrylate, t-butyl (meth)acrylate, pentyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate and octadecyl (meth)acrylate; cycloalkyl (meth)acrylates such as cyclohexyl (meth)acrylate; and aryl (meth)acrylates such as phenyl (rmeth)acrylate. The (meth)acrylic esters can be used either alone or in combination of two or more thereof. As the (meth)acrylic esters, there can be suitably used alkyl (meth)acrylates such as methyl (meth)acrylate, ethyl (meth)acrylate, butyl (meth)acrylate, 2-ethylhexyl (meth)acrylate and octyl (meth)acrylate. Herein, "(meth)acrylic ester" means both an acrylic ester and a methacrylic ester.

In the acrylic polymer, a copolymerizable monomers is used as a monomer ingredient for the purpose of modifying cohesive force, heat resistance and the like, as needed. Examples of such copolymerizable monomers include hydroxyl group-containing monomers such as 2-hydroxyethyl (meth)acrylate, 2-hydroxypropyl (meth)acrylate, 4-hydroxybutyl (meth)acrylate and 6-hydroxyhexyl (meth)acrylate; epoxy group-containing monomers such as glycidyl (meth)acrylate; carboxyl group-containing monomers such as (meth)acrylic acid (acrylic acid and methacrylic acid), itaconic acid, maleic acid, fumaric acid, crotonic acid and isocrotonic acid; acid anhydride group-containing monomers such as maleic anhydride and itaconic anhydride; amide-based monomers such as (meth)acrylamide, N,N-dimethyl(meth)acrylamide, N-butyl(meth)acrylamide, N-methylol(meth)acrylamide, N-methylolpropyl(meth)acrylamide, N-methoxymethyl (meth)acrylamide and N-butoxymethyl(meth)acrylamide; amino group-containing monomers such as aminoethyl (meth) acrylate, N,N dimethylaminoethyl (meth)acrylate and t-butylaminoethyl (naeth)acrylate; cyano group-containing monomers such as (meth)acrylonitrile; olefinic monomers such as ethylene, propylene, isopropylene, butadiene and isobutylene; styrenic monomers such as styrene, α-methylstyrene and vinyltoluene; vinyl ester-based monomers such as vinyl acetate and vinyl propionate; vinyl ether-based monomers such as methyl vinyl ether and ethyl vinyl ether; halogen atom-containing monomers such as vinyl chloride and vinylidene chloride; alkoxy group-containing monomers such as methoxyethyl (meth)acrylate and ethoxyethyl (meth)acrylate; and monomers having a nitrogen atom-containing ring such as N-vinyl-2-pyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-vinylmorpholine, N-vinylcaprolactam, and N-(meth)acryloylmorpholine. The copolymerizable monomers can be used alone or in combination of two or more thereof. These copolymerizable monomers are preferably used in an amount of 40% by weight or less based on the total monomer ingredients constituting the acrylic polymer.

As the copolymerizable monomer, there can be used a polyfunctional monomer for the purpose of crosslinking and the like, as needed. Examples of the polyfunctional monomers include 1,6-hexanediol (meth)acrylate, (poly)ethylene glycol di(meth)acrylate, (poly)propylene glycol di(meth)acrylate, neopentyl glycol di(meth)acrylate, pentaerythritol di (zrieth)acrylate, trimethylolpropane tri(meth)acrylate, pentaerythritol tri(meth)acrylate, dipentaerythritol hexa(meth)acrylate, glycerol di(meth)acrylate, an epoxy (meth)acrylate, a polyester (meth)acrylate, an urethane (meth)acrylate, divinylbenzene, butyl di(meth)acrylate, and hexyl di(meth)acrylate. The multifunctional monomers can be used either alone or in combination of two or more thereof. These multifunctional monomers are preferably used in an amount of 30% by weight or less based on the total monomer ingredients constituting the acrylic polymer, from the viewpoint of pressure-sensitive adhesive characteristics and the like.

Further, an ethylene-vinyl acetate copolymer, a vinyl acetate polymer or the like can also be used as the copolymerizable monomer ingredient, as needed.

The acrylic polymer can be prepared by polymerizing a single monomer ingredient or a mixture of two or more monomer ingredients. Further, the polymerization can be conducted by any polymerization system of a solution polymerization method, an emulsion polymerization method, a bulk polymerization method, a suspension polymerization method and the like.

In the invention, an acrylic polymer having a carbon-carbon double bond in the side chain or main chain thereof or at the end of the main chain thereof (sometimes referred to as a "double-bond introduction type acrylic polymer") can be suitably used as the acrylic polymer. In the case where the acrylic polymer is the double bond-introduced acrylic polymer, when the pressure-sensitive adhesive sheet having the removable pressure-sensitive adhesive layer formed is attached to the adherend and thereafter adhesion strength to the adherend is decreased by irradiation of an active energy ray, it becomes possible to more decrease the adhesion strength to the adherend without adding a low molecular weight ingredient such as an active energy ray-curable ingredient described below.

As such a double-bond introduction type acrylic polymer, there can be suitably used a double-bond introduction type acrylic polymer having one carbon-carbon double bond in each of 1/100 or more of all side chains within the molecule thereof (sometimes referred to as a "double-bond side-chain introduction type acrylic polymer"). Such introduction of carbon-carbon double bonds into side chains of the acrylic polymer is also advantageous from the standpoint of molecular design. This double-bond side-chain introduction type acrylic polymer may also have carbon-carbon double bonds in the main chain and at the end of the main chain. Such a double-bond introduction type acrylic polymer is not required to contain a low molecular weight ingredient such as an oligomer ingredient, and does not contain it in large amounts. Accordingly, the low molecular weight ingredient such as the oligomer ingredient is inhibited or prevented from migrating in the pressure-sensitive adhesive layer with the lapse of time. Consequently, when such a double-bond introduction type acrylic polymer is used as the acrylic polymer contained in the removable pressure-sensitive adhesive composition as an essential ingredient, the pressure-sensitive adhesive layer having a stable layer structure can be obtained.

A method for preparing the double-bond introduction type acrylic polymer (that is to say, a method for introducing carbon-carbon double bonds into the acrylic polymer) is not particularly limited, and a method appropriately selected from various known methods can be employed. Specifically, examples of methods for preparing the double-bond introduction type acrylic polymer (that is to say, methods for introducing carbon-carbon double bonds into the acrylic polymer) include a method which includes conducting a copolymerization using a functional group-containing monomer as a copolymerizable monomer to prepare an acrylic polymer containing the functional group (sometimes referred to as a "functional group-containing acrylic polymer"), and then, causing a compound having a functional group capable of reacting with the functional group contained in the functional group-containing acrylic polymer and a carbon-carbon double bond (sometimes referred to as a "carbon-carbon double bond-containing reactive compound") to undergo condensation reaction or addition reaction with the functional group-containing acrylic polymer in a state where active energy ray curability (active energy ray polymerizability) of the carbon-carbon double bond is maintained, thereby preparing the double-bond introduction type acrylic polymer. In addition, examples of the control means at the time when carbon-carbon double bonds are introduced into 1/100 or more of all side chains in the acrylic polymer include a method of suitably controlling the amount of the carbon-carbon double bond-containing reactive compound used, which is a compound to be subjected to condensation reaction or addition reaction with the functional group-containing acrylic polymer. Further, when the carbon-carbon double bond-containing reactive compound is subjected to condensation reaction or addition reaction with the functional group-containing acrylic polymer, the above-mentioned reaction can effectively proceed by using a catalyst. Although the catalyst is not particularly limited, a tin-based catalyst (particularly, dibutyltin dilaurate) is suitable. The amount of the catalyst (tin-based catalyst such as dibutyltin dilaurate) used is not particularly limited. For example, the amount thereof is preferably about 0.05 to 1 part by weight based on 100 parts by weight of the functional group-containing acrylic polymer.

In the double-bond side-chain introduction type acrylic polymer, the proportion of the side chains in each of which a carbon-carbon double bond is introduced is suitably 1/100 or more (from 1/100 to 100/100), particularly suitably from 10/100 to 98/100 (especially from 50/100 to 95/100), with respect to the number of functional groups (such as hydroxyl groups) in all side chains, as described above. Accordingly, the proportion of the side chains in which carbon-carbon double bonds are introduced in the double-bond side-chain introduction type acrylic polymer can be controlled, for example, by appropriately adjusting the amount of the carbon-carbon double bond-containing reactive compound used with respect to the number of functional groups in the functional group-containing acrylic polymer.

As the examples of combinations of the functional group in the functional group-containing acrylic polymer and the functional group in the carbon-carbon double bond-containing reactive compound, various combinations such as a combination of a carboxylic acid group (carboxyl group) and an epoxy group, a combination of a carboxylic acid group and an aziridyl group, a combination of a hydroxyl group and an isocyanate group, and the like may be mentioned. Of these combinations of functional groups, a combination of a hydroxyl group and an isocyanate group is suitable from the viewpoint of easiness of reaction traceability and the like. In these combinations of functional groups, either functional group may be the functional group on either side of the functional group-containing acrylic polymer and the carbon-carbon double bond-containing reactive compound. However, for example, in the case of a combination of a hydroxyl group and an isocyanate group, it is suitable that the hydroxyl group is the functional group in the functional group-containing acrylic polymer and the isocyanate group is the functional group in the carbon-carbon double bond-containing reactive compound. In this case, examples of the carbon-carbon double bond-containing reactive compounds containing an isocyanate group as the functional group (that is to say, carbon-carbon double bond-containing isocyanate-based compounds) include (meth)acryloyl isocyanate, (meth)acryloyloxymethyl isocyanate, 2-(meth)aayloyloxyethyl isocyanate, 2-(meth)acryloyloxypropyl isocyanate, 3-(meth)acryloyloxypropyl isocyanate, 4-(meth)acryloyloxybutyl isocyanate, m-propenyl-$\alpha,\alpha$-dimethylbenzyl isocyanate and the like. Further, examples of the functional group-containing acrylic polymers containing a hydroxyl group as the functional group include a hydroxyl group-containing acrylic polymer obtained by a copolymerization using a hydroxyl group-containing monomer [such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)methyl (meth)acrylate, vinyl alcohol, allyl alcohol, 2-hydxoxyethyl vinyl ether, 2-hydroxypropyl vinyl ether, 4-hydroxybutyl vinyl ether, ethylene glycol monovinyl ether, diethylene glycol monovinyl ether, propylene glycol monovinyl ether or dipropylene glycol monovinyl ether] as a copolymerizable monomer.

When the pressure-sensitive adhesive sheet having the removable pressure-sensitive adhesive layer is used as the pressure-sensitive adhesive sheet for dicing, from the viewpoint of contamination prevention of the material to be processed such as a semiconductor wafer, it is preferred that the acrylic polymer has a low content of low molecular weight substances. From this viewpoint, the weight average molecular weight of the acrylic polymer is preferably 500,000 or more (for example, from 500,000 to 5,000,000), and more preferably from about 800,000 to 3,000,000. When the weight average molecular weight of the acrylic polymer is less than 500,000, properties of preventing contamination to the material to be processed such as the semiconductor wafer may be reduced, whereby an adhesive residue may occur after the separation in some cases.

It is important that the acrylic polymer has a functional group having reactivity with a crosslinking agent and a photopolymerization initiator (reactive functional group: for example, a hydroxyl group or a carboxyl group, particularly a hydroxyl group). This is because it is important that the acrylic polymer is chemically bonded to the photopolymerization initiator directly or through the crosslinking agent, in order to prevent the defect that adhesion strength is not decreased when the active energy ray is irradiated, which is caused by migration of the photopolymerization initiator in the removable pressure-sensitive adhesive layer (the defect that, in the case of using the pressum-sensitive adhesive sheet having the removable pressure-sensitive adhesive layer as the pressure-sensitive adhesive sheet for dicing, when the sheet is attached to the material to be processed, processing the material to be processed, and then separating the sheet therefrom, the adhesion strength is not decreased even by the irradiation of the active energy ray).

The photopolymerization initiator is an essential low molecular weight ingredient contained in the removable pressure-sensitive adhesive composition, and is not limited so long as it is linkable to a main chain or a side chain of a pressure-sensitive adhesive resin (for example, the acrylic polymer). However, it is preferably a photopolymerization initiator having a reactive functional group within the molecule thereof. This is because it is important that the photopolymerization initiator in the removable pressure-sensitive adhesive layer is chemically bonded to the acrylic polymer directly or through the crosslinking agent to thereby prevent migration thereof to the substrate side, in order to prevent the defect that adhesion strength is not decreased when the active energy ray is irradiated, which is caused by migration of the photopolymerization initiator in the removable pressure-sensitive adhesive layer (the defect that, in the case of using the pressure-sensitive adhesive sheet having the removable pressure-sensitive adhesive layer as the pressure-sensitive adhesive sheet for dicing, when the sheet is attached to the material to be processed, processing the material to be processed, and then separating the sheet therefrom, the adhesion strength is not decreased even by the irradiation of the active energy ray).

The photopolymerization initiator having a hydroxyl group as the reactive functional group within the molecule thereof is preferred among others. Examples of such photopolymerization initiators include, a benzophenone derivative, and an alkylphenone derivative. Specific examples of the benzophenone derivatives include o-acryloxybenzophenone; p-acryloxybenzophenone; o-methacryloxybenzophenone; p-methacryloxybenzophenone; p-(meth)acryloxyethoxybemophenone; and benzophenone-4-carboxylic acid esters of acrylates such as 1,4-butanediol mono(meth)acrylate, 1,2-ethanediol mono(meth)acrylate and 1,8-octanediol mono(meth)acrylate. In addition, specific examples of the alkylphenone derivatives include 1-[4-(2-hydroxyethoxy)phenyl]-2-hydroxy-2methyl-1-propane-1-one (trade name: "Irgacure 2959", manufactured by Ciba Specialty Chemicals Co.), and 2-hydroxy-1-{4-[4-(2-hydroxy-2rmethylpropionyl)benzyl] phenyl}-2-methylpropane-1-one (trade name: "Irgacure 127", manufactured by Ciba Specialty Chemicals Co.). The photopolymerization initiators can be used either alone or in combination of two or more thereof

The amount of the photopolymerization initiator incorporated can be appropriately selected from the range of 0.1 to 10 parts by weight, preferably 0.5 to 5 parts by weight, based on 100 parts by weight of the acrylic polymer contained in the removable pressure-sensitive adhesive composition.

Further, the crosslinking agent is an essential ingredient contained in the removable pressure-sensitive adhesive composition, and is used for increasing the weight average molecular weight of the acrylic polymer, and for linking the photopolymerization initiator to the acrylic polymer therethrough. The crosslinking agent is chemically bonded to both the acrylic polymer and the photopolymerization initiator in the removable pressure-sensitive adhesive layer, thereby inhibiting migration of the photopolymerization initiator.

Such a crosslinking agent is not particularly limited so long as it has a functional group (reactive functional group) capable of reacting with reactive functional groups contained in the acrylic polymer and the photopolymerization initiator. Examples thereof include a polyisocyanate-based crosslinking agent, an epoxy-based crosslinking agent, an aziridine-based crosslinking agent, a melamine resin-based crosslinking agent, a urea resin-based crosslinking agent, an acid anhydride compound-based crosslinking agent, a polyamine-based crosslinking agent, and a carboxyl group-containing polymer-based crosslinking agent.

For example, when the acrylic polymer and the photopolymerization initiator have hydroxyl groups as the reactive functional groups, the crosslinking agent is preferably a polyisocyanate-based crosslinking agent having an isocyanate group as the reactive functional group. That is to say, when the removable pressure-sensitive adhesive composition contains, as essential ingredients, the acrylic polymer having a hydroxyl group as the reactive functional group, the photopolymerization initiator having a hydroxyl group as the reactive functional group and the polyisocyanate-based crosslinking agent having an isocyanate group as the reactive functional group, it is preferable that the acrylic polymer and the crosslinking agent as well as the photopolymerization initiator and the crosslinking agent in the removable pressure-sensitive adhesive composition or the removable pressure-sensitive adhesive layer are respectively bonded by a chemical bond between an isocyanate group and a hydroxyl group.

The polyisocyanate-based crosslinking agent is not particularly limited, and examples thereof include an aliphatic polyisocyanate, an alicyclic polyisocyanate, an aromatic polyisocyanate, an aromatic alicyclic polyisocyanate, and a dimer or trimer, reaction product or polymer thereof. Specifically, examples of the polyisocyanate-based crosslinking agents include tolylene diisocyanate, hexamethylene diisocyanate, polymethylenepolyphenyl isocyanate, diphenylmethane diisocyanate, a dimer of diphenylmethane diisocyanate, a reaction product of trimethylolpropane and tolylene diisocyanate, a reaction product of trimethylolpropane and hexamethylene diisocyanate, a polyether polyisocyanate, and a polyester polyisocyanate.

The amount of the crosslinking agent used can be appropriately selected depending on a balance with a base polymer to be crosslinked (acrylic polymer before crosslinking), the use application as a pressure-sensitive adhesive, and the like. In general, the amount of the crosslinking agent used is preferably from 0.01 to 10 parts by weight, more preferably from 1 to 3 parts by weight, based on 100 parts by weight of the base polymer to be crosslinked (acrylic polymer before crosslinldng).

The removable pressure-sensitive adhesive composition may contain known additives such as a tackifier, an age resistor, a filler, a colorant, a flame retardant, an antistatic agent, a softener, an ultraviolet absorber, an antioxidant, a plasticizer and a surfactant, according to the necessity.

The removable pressure-sensitive adhesive composition may further contain an active energy ray-curable ingredient as an essential ingredient, in addition to the acrylic polymer, the photopolymerization initiator and the crosslinking agent. In the case where the removable pressure-sensitive adhesive composition further contains the active energy ray-curable ingredient as the essential ingredient, when the pressure-sensitive adhesive sheet having the removable pressure-sensitive adhesive layer formed is attached to the adherend and thereafter adhesion strength to the adherend is decreased by irradiation of an active energy ray, it becomes possible to more significantly decrease the adhesion strength to the adherend.

The active energy ray-curable ingredient is not particularly limited, so long as it is a compound having an active energy ray-polymerizable (polymerizable by irradiation of an active energy ray) functional group, such as a carbon-carbon double bond-containing group (sometimes referred to as a "carbon-carbon double bond-containing group), and may be either a monomer ingredient or a oligomer ingredient. Specifically, examples of the active energy ray-curable ingredient include esterified products of (meth)acrylic acid and polyhydric alcohols, such as trimethylolpropane tri(meth) acrylate, pentaerythritol tri(meth)acrylate, tetraethylene glycol di(meth)acrylate, 1,6-hexanediol di(meth)acrylate, neopentyl glycol di(meth)acrylato, dipentaerythritol hexa(meth)acrylate and glycerol di(meth)acrylate; ester acrylate oligomers; cyanurate-based compounds having a carbon-carbon double bond-containing group, such as 2-propenyl-di-3-butenyl cyanurate; and isocyanurate-based compounds having a carbon-carbon double bond-containing group, such as tris(2-acryloxyethyl) isocyanurate, tris(2-methacryloxyethyl) isocyanurate, 2-hydroxyethyl bis(2-acryloxyethyl) isocyanurate, bis(2-acryloxyethyl) 2-[(5-acryloxyhexyl)oxy]ethyl isocyanurate, tris(1,3-diacryloxy-2-propyl-oxycarbonylamino-n-hexyl) isocyanurate, tris(1-acryloxyethyl-3-methacryloxy-2-propyl-oxycarbonylamino-n-hexyl) isocyanurate and tris(4-acryloxy-n-butyl) isocyanurate. As the active energy ray-curable ingredient, there can be suitably used one having 6 or more carbon-carbon double bond-containing groups on average within the molecule thereof such as dipentaerythritol hexa(meth)acrylate.

The viscosity of the active energy ray-curable ingredient is not particularly limited. The active energy ray-curable ingredients can be used either alone or in combination of two or more thereof.

The amount of the active energy ray-curable ingredient incorporated is not particularly limited. However, in the case where the pressure-sensitive sheet having the removable pressure-sensitive adhesive layer is used for dicing, it is preferably from 10 to 300 parts by weight, and more preferably from 30 to 150 parts by weight, in view of decreasing the adhesion strength in picking up, i.e., in peeling after irradiation of the active energy ray.

When the double-bond introduction type acrylic polymer is used as the acrylic polymer, the active energy ray-curable ingredient may be contained to such a degree as not to deteriorate characteristics, or may not be contained. That is to say, the use of the active energy ray-curable ingredient in the removable pressure-sensitive adhesive composition is optional. Accordingly, the removable pressure-sensitive adhesive composition may contain, as the essential ingredients, the double-bond introduction type acrylic polymer, the photopolymerization initiator, the crosslinking agent and the active energy ray-curable ingredient; or may contain, as the essential ingredients, the double-bond introduction type acrylic polymer, the photopolymerization initiator, and the crosslinking agent.

Pressure-Sensitive Tape or Sheet

The invention will be illustrated in detail below with reference to drawings. The pressure-sensitive adhesive sheet has at least the pressure-sensitive adhesive layer (removable pressure-sensitive adhesive layer) formed by the removable pressure-sensitive adhesive composition. Accordingly, the pressure-sensitive adhesive sheet of the invention has such characteristics that it exhibits excellent pressure-sensitive adhesive properties, when attached to the adherend (material to be processed), whereas it exhibits excellent releasability due to a decrease in the adhesion strength thereof by irradiation of the active energy ray, when separated from the adherend (material to be processed). The pressure-sensitive adhesive sheet of the invention is therefore suitably used for applications requiring such characteristics, for example, for dicing applications.

Further, the pressure-sensitive adhesive sheet of the invention is not particularly limited, so long as it has at least the removable pressure-sensitive adhesive layer. For example, it may be either a pressure-sensitive adhesive sheet constituted only of the removable pressure-sensitive adhesive layer (a substrateless pressure-sensitive adhesive sheet) or a pressure-sensitive adhesive sheet having a constitution that the removable pressure-sensitive adhesive layer is disposed on one side or both sides of a substrate (a pressure-sensitive adhesive sheet with a substrate). Furthermore, the form (mode), shape and the like thereof are not particularly limited. The pressure-sensitive adhesive sheet of the invention may have another layer, such as an intermediate layer, or an undercoat layer.

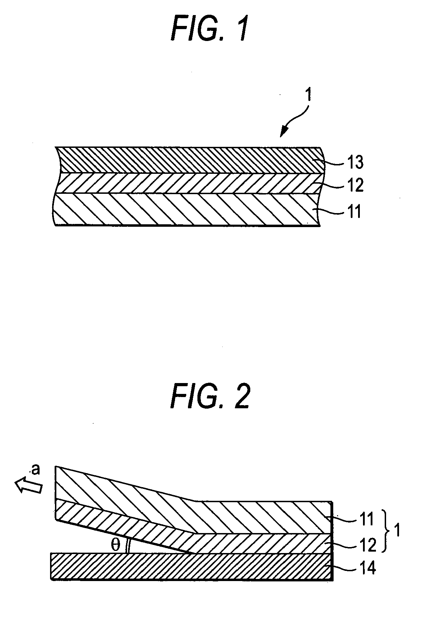

Examples of the form of the pressure-sensitive adhesive sheet of the invention include a form of a single-sided pressure-sensitive adhesive sheet in which only one side of the substrate is a pressure-sensitive surface (adhesive surface), and a form of a double-sided pressure-sensitive adhesive sheet in which both sides of the substrate are pressure-sensitive surfaces. More specifically, examples thereof include a form of a single-sided pressure-sensitive adhesive sheet in which the removable pressure-sensitive adhesive layer is disposed on one side of the substrate as shown in Fig. 1, a form of a substrateless pressure-sensitive adhesive sheet constituted only of the removable pressure-sensitive adhesive layer, a form of a double-sided pressure-sensitive adhesive sheet having a constitution that the removable pressure-sensitive adhesive layers are disposed on both sides of the substrate, and a form of a double-sided pressure-sensitive adhesive sheet having a constitution that the removable pressure-sensitive adhesive layer is disposed on one side of the substrate and a pressure-sensitive adhesive layer other than the removable pressure-sensitive adhesive layer is disposed on the other side.

Further, the pressure-sensitive adhesive sheet of the invention can take an appropriate shape depending on the applications thereof. For example, when it is used for wafer dicing application, one previously cut to a specified shape is suitably used.

The pressure-sensitive adhesive layer other than the removable pressure-sensitive adhesive layer can be formed, for example, using a known pressure-sensitive adhesive (such as an acrylic pressure-sensitive adhesive, a rubber-based pressure-sensitive adhesive, a vinyl alkyl ether-based pressure-sensitive adhesive, a silicone-based pressure-sensitive adhesive, a polyester-based pressure-sensitive adhesive, a polyamide-based pressure-sensitive adhesive, a urethane-based pressure-sensitive adhesive, a fluorine-based pressure-sensitive adhesive, or an epoxy-based pressure-sensitive adhesive) by a known method for forming the pressure-sensitive adhesive layer. The thickness of the pressure-sensitive adhesive layer other than the removable pressure-sensitive adhesive layer is not particularly limited, and can be appropriately selected depending on the purpose and method of use.

Fig. 1 is a schematic sectional view showing one embodiment of the pressure-sensitive adhesive sheet of the invention. In Fig. 1, numeral 1 is a pressure-sensitive adhesive tape or sheet, numeral 11 is a substrate, numeral 12 is a removable pressure-sensitive adhesive layer, and numeral 13 is a separator (release film). The pressure-sensitive adhesive sheet 1 shown in Fig. 1 has a constitution that the removable pressure-sensitive adhesive layer 12 is formed on one side of the substrate 11 and the separator 13 is further laminated on the removable pressure-sensitive adhesive layer 12. In the pressure-sensitive adhesive sheet of the invention, the separator is appropriately provided according to the necessity. However, from the viewpoints of protecting a pressure-sensitive adhesive surface of the pressure-sensitive adhesive layer, label processing and smoothening the pressure-sensitive adhesive layer, it is preferred that the separator is provided, in such a manner as with the separator 13 in the pressure-sensitive adhesive sheet 1 shown in Fig. 1.

The pressure-sensitive adhesive sheet of the invention may be formed in a wound roll-like form or in a laminated sheet-like form. That is to say, the pressure-sensitive adhesive sheet of the invention can have a roll-like or sheet-like form. The pressure-sensitive adhesive sheet wound in a roll-like form may have a wound roll-like state or form in a state where the pressure-sensitive adhesive surface is protected with the separator (release film), or in a state where the pressure-sensitive adhesive surface is protected with a release-treated layer (back surface-treated layer) formed on the other side of a substrate. Examples of the release treatment agent (release agents) used in forming the release-treated layer (back surface-treated layer) on the surface of the substrate include a silicone-based release agent, and an alkyl-based release agent.

Substrate

In the pressure-sensitive adhesive sheet, the substrate (substrate film) acts as a mother body for strength, and is not particularly limited. The substrate may be any of a plastic substrate, a metal substrate, a fiber substrate, a paper substrate and the like, and a plastic substrate can be suitably used. Examples of the plastic substrate include a plastic film or sheet. Examples of the material constituting the plastic film or sheet include polyolefinic resins (such as low-density polyethylene, linear polyethylene, medium-density polyethylene, high-density polyethylene, ultralow-density polyethylene, random-copolymerized polypropylene, block-copolymerized propylene, homopolypropylene, polybutene, and polymethylpentene), ethylene-vinyl acetate copolymers, ionomer resins, ethylene-(meth)acrylic acid copolymers, ethylene-(meth)acrylic ester copolymers (such as a random copolymer and an alternating copolymer), ethylene-butene copolymers, ethylene-hexene copolymers, polyurethanes, polyester-based resins (such as polyethylene terephthalate, polyethylene naphthalate, polybutylene terephthalate and polybutylene naphthalate), polyimides, polyamides, polyetherketones, polyethers, polyethersulfones, polystyrenic resins (such as polystyrene), polyvinyl chloride, polyvinylidene chloride, polyvinyl alcohol, polyvinyl acetate, vinyl chloride-vinyl acetate copolymers, urethane-vinyl chloride copolymers, ethylene-vinyl chloride copolymers, vinyl acetate-vinyl chloride copolymers, polycarbonates, fluororesins, cellulosic resins, and crosslinked materials of these resins. In the constituent material of the plastic film or sheet, a functional group may be optionally incorporated, and a functional monomer or modifying monomer may be optionally grafted thereon.

When the pressure-sensitive adhesive sheet is used as the pressure-sensitive adhesive sheet for dicing, since sufficient distance between chip elements can be easily obtained in the expanding step after dicing, a soft polyvinyl chloride-based substrate in which polyvinyl chloride, a vinyl chloride copolymer (such as a random copolymer or an alternating copolymer) such as an urethane-vinyl chloride copolymer, an ethylene-vinyl chloride copolymer and a vinyl acetate-vinyl chloride copolymer or the like is used as a main material constituting the plastic film or sheet is preferred among the plastic substrates. In the soft polyvinyl chloride-based substrate, there are usually incorporated a plasticizer (for example, a phthalic ester such as dibutyl phthalate, dioctyl phthalate, dinonyl phthalate or diisodecyl phthalate; a polyester-based plasticizer; an epoxy-based plasticizer; a trimellitic plasticizer or the like) and a stabilizer according to the necessity.

The surface of the substrate may be subjected to known or commonly used surface treatment (for example, chemical or physical treatment such as corona discharge treatment, chromic acid treatment, ozone exposure treatment, flame exposure treatment, high-voltage electric-shock exposure treatment or ionizing radiation treatment, coating treatment with an undercoating agent, primer treatment, matting treatment or crosslinking treatment), in order to enhance adhesiveness to an adjacent layer (for example, the pressure sensitive adhesive layer such as the removable pressure-sensitive adhesive layer) or holding properties. Further, in order to impart antistatic properties, a vapor-deposited layer of a conductive substance such as a metal, an alloy or an oxide thereof may be formed on the substrate. The thickness of the vapor-deposited layer of such a conductive substance is generally from about 30 to 500 angstroms.

As the substrate, there is suitably used one which at least partly transmits an active energy ray (for example, an X-ray, ultraviolet light, an electron beam or the like) so that the removable pressure-sensitive adhesive layer can be cured even when the layer is irradiated with the active energy ray from the substrate side.

The substrate may have either a single-layer form or a laminated form. Further, the substrate may optionally contain known additives such as a filler, a flame retardant, an age resistor, an antistatic agent, a softener, an ultraviolet absorber, an antioxidant, a plasticizer and a surfactant. Furthermore, the substrate may be a blend substrate obtained by dry blending two or more of the above-mentioned resins.

A method for forming the substrate is not particularly limited, and can be appropriately selected from known or commonly used forming methods to be employed. Examples of the methods for forming the plastic substrate include a calender film forming method, a cast film forming method, an inflation extruding method, and a T-die extruding method. Further, when the plastic substrate has a constitution in which multiple layers are laminated, it can be formed utilizing a laminating method such as a coextrusion method or a dry laminating method. The plastic substrate may be in an unstretched state or in a state uniaxially or biaxially stretched by stretching treatment.

The thickness of the substrate is not particularly limited, and can be appropriately determined. For example, it is preferably from 10 to 300 $\mu$m, more preferably from 30 to 200 $\mu$m, and still more preferably from 50 to 150 $\mu$m.

Removable Pressure-Sensitive Adhesive Layer

The removable pressure-sensitive adhesive layer is a pressure-sensitive adhesive layer formed by the above-mentioned removable pressure-sensitive adhesive composition. In the pressure-sensitive adhesive sheet of the invention, the layer exhibits excellent pressure-sensitive adhesive properties, when attached to the adherend (material to be processed), whereas it provides a pressure-sensitive adhesive surface exhibiting excellent releasability due to a decrease in the adhesion strength by curing caused by an increase in the degree of crosslinking thereof by irradiation of an active energy ray, when separated from the adherend (material to be processed). Further, the removable pressure-sensitive adhesive layer is formed by the above-mentioned removable pressure-sensitive adhesive composition, so that it inhibits migration of the photopolymerization initiator which is a low molecular weight ingredient (for example, when the pressure-sensitive adhesive sheet of the invention is a pressure-sensitive sheet having the removable pressure-sensitive adhesive layer on at least one side of the substrate, migration of the photopolymerization initiator which is a low molecular weight ingredient to the substrate side) to thereby make it possible to inhibit the defect that the adhesion strength is not decreased even when the active energy ray is irradiated.

The removable pressure-sensitive adhesive layer can be formed utilizing a known forming method of the pressure-sensitive adhesive layer with using the removable pressure-sensitive adhesive composition. For example, the removable pressure-sensitive adhesive layer can be formed on the substrate by a method of applying the removable pressure-sensitive adhesive composition to a specified side of the substrate to form the layer, or a method of applying the removable pressure-sensitive adhesive composition onto a separator (for example, a plastic film or sheet coated with a release agent) to form the removable pressure-sensitive adhesive layer and then transferring the removable pressure-sensitive adhesive layer to a specified side of the substrate. The pressure-sensitive adhesive sheet of the invention can be prepared by forming the removable pressure-sensitive adhesive layer on the substrate by the above-mentioned method, and then optionally laminating a separator on the removable pressure-sensitive adhesive layer in such a form that a pressure-sensitive adhesive surface and a release-treated surface of the separator come into contact with each other.

The thickness of the removable pressure-sensitive adhesive layer is not particularly limited. However, it is usually set to an appropriate thickness used in pressure-sensitive adhesive sheets. For example, when the pressure-sensitive adhesive sheet of the invention is used for dicing application of silicon wafers and the like, it is preferably from 1 to 50 $\mu$m. When the pressure-sensitive adhesive sheet of the invention is used as the pressure-sensitive adhesive sheet for dicing, the adherend (material to be processed) attached vibrates during dicing thereof in some cases. In such a case, when the amplitude of vibration is large, chipping sometimes occurs in cut pieces (cut chips) of the material to be processed. However, when the thickness of the removable pressure-sensitive adhesive layer is adjusted to 50 $\mu$m

or less, the amplitude of vibration occurring in dicing the material to be processed can be inhibited from becoming too large. As a result, a decrease in the phenomenon that chipping occurs in cut chips (a decrease in so-called "chipping") can be effectively attained. Additionally, when , the thickness of the removable pressure-sensitive adhesive layer is adjusted to 1 μm or more, it becomes possible to surely hold the material to be processed which is attached onto the removable pressure-sensitive adhesive layer so that the material to be processed is not easily separated in dicing. In particular, the removable pressure-sensitive adhesive layer has suitably a thickness of 3 to 20 μm. By adjusting the thickness of the removable pressure-sensitive adhesive layer to 3 to 20 μm as described above, a further decrease in chipping of the material to be processed in dicing can be attained, and the material to be processed can be more surely fixed in dicing. Thus, the occurrence of dicing failures can be effectively inhibited or prevented. The removable pressure-sensitive adhesive layer may have either a single-layer form or a laminated form.

Separator

The separator (release film) is not particularly limited, and can be appropriately selected from known separators to use, Examples of the constituent material of the separator (materials of the substrate) include paper; and synthetic resin films made of synthetic resins such as polyethylene, polypropylene and polyethylene terephthalate. A surface of the separator may be optionally subjected to a release treatment (mold releases treatment) such as silicone treatment, long-chain alkyl treatment or fluorine treatment, in order to enhance releasability from the pressure-sensitive adhesive layer such as the removable pressure-sensitive adhesive layer. Furthermore, in order to prevent the removable pressure-sensitive adhesive layer from reacting with environmental ultraviolet light, the separator may be optionally subjected to an ultraviolet-shielding treatment. The thickness of the separator is not particularly limited, and it is generally from 10 to 200 μm, preferably from 25 to 100 μm.

In the invention, the adhesion strength on the pressure-sensitive adhesive surface of the removable pressure-sensitive adhesive layer is appropriately set according to the necessity. However, when the pressure-sensitive adhesive sheet of the invention is used as the pressure-sensitive adhesive sheet for dicing, there can be suitably used one whose adhesion strength is decreased by irradiation of the active energy ray, and whose peeling adhesion strength (peel angle: 15°; pulling rate: 150 mm/min; temperature: 23±3°C) against a silicon mirror wafer can be controlled to 2.3 (N/25 mm width) or less, particularly 1,2 (N/25 mm width) or less. When the adhesion strength (against a silicon mirror wafer, peel angle: 15°; pulling rate: 150 mm/min; temperature: 23±3°C) can be controlled to 2.3 (N/25 mm width) or less as described above, pickup properties are improved, and an adhesive residue (a residue of the adhesive ingredient) can be decreased. Accordingly, the adhesion strength (against a silicon mirror wafer, peel angle: 15°; pulling rate: 150 mm/min; temperature: 23±3°C) on the pressure-sensitive adhesive surface of the removable pressure-sensitive adhesive layer may be 2.3 (N/25 mm width) or less from the beginning, or the adhesion strength (against a silicon mirror wafer, peel angle: 15°; pulling rate: 150 mm/min; temperature: 23±3°C) may be decreased to 2.3 (N/25 mm width) or less by lowering the adhesion strength.

The lower limit of the peeling adhesion strength (peel angle: 90°; pulling rate: 300 mm/min; temperature: 23±3°C) against a silicon mirror wafer at the time of dicing is preferably 1.0 (N/25 mm width) or more, and more preferably 3.0 (N/25 mm width) or more. When the peeling adhesion strength (peel angle: 90°; pulling rate: 300 mm/min; temperature: 23±3°C) against a silicon mirror wafer at the time of dicing is less than 1.0 (N/25 mm width), cut pieces are sometimes scattered when the material to be processed is diced.

That is to say, when the pressure-sensitive adhesive sheet of the invention is used as the pressure-sensitive adhesive sheet for dicing, the adhesion strength on the pressure-sensitive adhesive surface of the removable pressure-sensitive adhesive layer before irradiation of the active energy ray is preferably 1.0 (N/25 mm width) or more in terms of the peeling adhesion strength (peel angle: 90°; pulling rate: 300 mm/min; temperature: 23±3°C) against a silicon mirror wafer. Furthermore, the adhesion strength on the pressure-sensitive adhesive surface of the removable pressure-sensitive adhesive layer after irradiation of the active energy ray is not particularly limited, so long as the adhesion strength decreases in terms of the peeling adhesion strength (peel angle; 15°; pulling rate: 150 mm/min; temperature: 23±3°C) against a silicon mirror wafer, compared to that before irradiation of the active energy ray, and further, the adhesion strength after the decrease becomes 2.3 (N/25 mm width) or less.

The adhesion strength of the removable pressure-sensitive adhesive layer after ultraviolet light irradiation is defined as the value determined by attaching the pressure-sensitive adhesive layer to a silicon mirror wafer, then, peeling the adhesive layer therefrom in a pulling direction a at a measuring temperature of 23±3°C and a pulling rate of 150 mm/min, with the angle between the surface of the removable pressure-sensitive adhesive layer and the surface of the silicon mirror wafer kept at 15°, as shown in Fig. 2, measuring the stress at the time of this peeling, and then reading the maximum value (maximum value excluding a peak top in an initial stage of the measurement) to take the maximum value of the stress as the adhesion strength (N/25 mm width). The reasons why the adhesion strength of the removable pressure-sensitive adhesive layer is specified using the silicon mirror wafer are that the state of the roughness of the surface of the silicon mirror wafer is constantly smooth and that the material of the silicon mirror wafer is the same as that of the semiconductor wafer or the like for use as the material to be processed which is subjected to dicing and pickup. Further, the reason why the adhesion strength at $23 \pm 3°C$ is used as a standard is that pickup is usually performed in an environment of room temperature (23°C). Herein, adhesion strength of the removable pressure-sensitive adhesive layer before ultraviolet light irradiation is defined in the same manner as in the adhesion strength of the removable pressure-sensitive adhesive layer after ultraviolet light irradiation, except for changing the angle θ between the surface of the removable pressure-sensitive adhesive layer and the surface of the silicon mirror wafer to 90°, and the pulling rate to 300 mm/min.

Fig. 2 is a schematic sectional view showing a method for measuring the adhesion strength of the pressure-sensitive adhesive sheet after ultraviolet light irradiation. In Fig. 2, numeral 14 is a silicon mirror wafer, symbol θ is the angle (peel angle) between a surface of a removable pressure-sensitive adhesive layer 12 and a surface of the silicon mirror wafer 14, symbol a is a direction in which a pressure-sensitive adhesive sheet 1 is peeled (a pulling direction), numeral 11 is a substrate, and numeral 12 is a removable pressure-sensitive adhesive layer. In Fig. 2, the pressure-sensitive adhesive sheet 1 attached to one side of the silicon mirror wafer 14 is peeled at a pulling rate of 150 mm/min in the pulling direction of symbol a with a peel angle θ of 15° kept constant. Measurement of the adhesion strength is made in an atmosphere of 23°C. As the silicon mirror wafer, there is used a silicon mirror wafer subjected to mirror finishing at 23°C [trade name: "CZN <100>2.5-3.5 (4 inches)", manufactured by Shin-Etsu Semiconductor Co., Ltd].

Further, when used as the pressure-sensitive adhesive sheet for dicing, the pressure-sensitive adhesive sheet of the invention preferably has the characteristic that the difference $C_1-C_2$ between the surface carbon element proportion $C_1$ (%) and the surface carbon element proportion $C_2$ (%) (sometimes referred to as the "increased amount of organic matter contamination; $\Delta C$") is 5% or less (for example, from 1% to 5%). Herein, the surface carbon element proportion $C_1$ (%) is that on the surface of the silicon mirror wafer after a pressure-sensitive adhesive surface provided by the removable pressure-sensitive adhesive layer has been attached thereto, dicing has been performed, and then, the active energy ray has been irradiated to remove the sheet therefrom. Additionally, the surface carbon element proportion $C_2$ (%) is that on the surface of the silicon mirror wafer before the sheet is attached thereto. When $\Delta C$ is 5% or less as described above, contamination caused by the pressure-sensitive adhesive sheet is extremely decreased, which makes it possible to reduce the occurrence of a so-called "adhesive residue", Thus, it becomes possible to improve the yield in processing of the material to be processed.

Further, viscoelasticity of the removable pressure-sensitive adhesive layer in the pressure-sensitive adhesive sheet of the invention is preferably within the range of 0 to 0.5 in terms of the value of loss tangent (tanδ) at 25°C from the viewpoint of stress relaxation (vibrational absorption). For example, when the pressure-sensitive adhesive sheet having a value of loss tangent (tanδ) within such a range is used as the pressure-sensitive adhesive sheet for dicing, it is possible to inhibit the problem that chipping occurs in cut pieces (cut chips) of the material to be processed, due to vibration which occurs in dicing the material to be processed (adherend) attached thereto.

The value of loss tangent (tanδ) at 25°C is calculated using the following equation (2) from the values of the storage elasticity G' and the loss elasticity G" at 25°C, which are measured by punching a measuring sample (thickness: 3 mm, treated in an autoclave for defoaming) of the removable pressure-sensitive adhesive layer into a disc form having a diameter of 7.9 mm, sandwiching it between parallel plates, and changing the temperature from -5°C to 75°C at a programming rate of 10°C/min while applying a shear strain of a frequency of 1 Hz, using a viscoelasticity tester, ARES, manufactured by Rheometric Science, Inc.

$$\text{Loss tangent (tan}\delta) = \text{loss elasticity G"/storage elasticity G'} \qquad (2)$$

Furthermore, with respect to wettability of the surface of the removable pressure-sensitive adhesive layer to water (compatibility of the surface of the removable pressure-sensitive adhesive layer with water), the pressure-sensitive adhesive sheet of the invention preferably has a contact angle of 90° or less (for example, 0 to 90°) after an elapse of 1 minute after dropping water to the surface of the removable pressure-sensitive adhesive layer using a syringe. When it is more than 90°, for example, wettability (adhesiveness) to the adhesive is decreased, so that there is a possibility that the material to be processed is separated during dicing.

The adherend (material to be processed) to which the pressure-sensitive adhesive sheet of the invention is used is not particularly limited. For example, when the sheet is used as the pressure-sensitive adhesive sheet for dicing, examples thereof include a semiconductor wafer, a semiconductor package, a ceramic, and glass.

In the case where the pressure-sensitive adhesive sheet of the invention is used as the pressure-sensitive adhesive sheet for dicing, the sheet exhibits excellent pressure-sensitive adhesive properties, when attached to the adherend (material to be processed) such as a semiconductor wafer, thereby being able to effectively prevent separation of chips during dicing. On the other hand, it exhibits excellent releasability due to a decrease in adhesion strength thereof by irradiation of the active energy ray, thereby being able to effectively perform pickup of chips during picking up. Further, contamination transferred at the time of attaching the sheet to the adherend is extremely decreased, which makes it possible to reduce the occurrence of the so-called "adhesive residue". Furthermore, no problems occur also with regard to viscoelasticity (stress relaxation) of the removable pressure-sensitive adhesive layer and wettability of the surface of the removable pressure-sensitive adhesive layer to water (compatibility with water).

Method for Picking Up Cut Pieces of Material to Be Processed

In a method for picking up the material to be processed (for example, a semiconductor part such as a semiconductor wafer) using the pressure-sensitive adhesive sheet of the invention as the pressure-sensitive adhesive sheet for dicing, the above-mentioned pressure-sensitive adhesive sheet is attached to the material to be processed, followed by dicing, and thereafter, cut pieces are picked up. Since the above-mentioned pressure-sensitive adhesive sheet is used as the pressure-sensitive adhesive sheet for dicing in dicing the material to be processed and picking up the cut pieces as described above, it is possible to easily pickup the cut pieces of the material to be processed by irradiation of the active energy ray even after the pressure-sensitive adhesive sheet has been attached to the material to be processed for a long period of time, and the yield can be thus improved. Moreover, according to the above-mentioned pickup method, even when a thin brittle semiconductor wafer (semiconductor element) having a thickness of less than 100 $\mu$m is used as the material to be processed, semiconductor chips obtained by dicing the semiconductor wafer into a specified size can be easily picked up, and the yield can be thus effectively improved.

As described above, in the method of picking up the material to be processed using the pressure-sensitive adhesive sheet of the invention, there are performed at least a mounting step for attaching the pressure-sensitive adhesive sheet to the material to be processed; a dicing step for dicing (separately cutting) the material to be processed after the mounting step; and a pickup step for picking up the cut pieces of the material to be processed after the dicing step.

The mounting step is performed in order to attach the pressure-sensitive adhesive sheet to the material to be processed. In the mounting step, the pressure-sensitive adhesive sheet is superposed on the material to be processed such as a semiconductor wafer so that the pressure-sensitive adhesive surface of the removable pressure-sensitive adhesive layer comes into contact with the material to be processed, and the pressure-sensitive adhesive sheet is attached to the material to be processed, while pressing them with a know pressing device such as a pressure roll. Additionally, the pressure-sensitive adhesive sheet may be attached to the material to be processed by superposing the pressure-sensitive adhesive sheet on the material to be processed in a pressurizable vessel (for example, in an autoclave) in the same manner as described above, and pressurizing the inside of the vessel. When attached by this pressurization, the pressure-sensitive adhesive sheet may be attached to the material to be processed while further pressing them with a pressing device. Furthermore, it is also possible to attach the pressure-sensitive adhesive sheet to the material to be processed in a reduced-pressure chamber (vacuum chamber) in the same manner as described above. Although the attaching temperature in attaching the sheet to the material to be processed is not particularly limited, it is preferably from 20 to 80°C.

The dicing step is performed in order to produce cut pieces of the material to be processed (such as semiconductor chips) by dicing the material to be processed (such as a semiconductor wafer) attached to the pressure-sensitive adhesive sheet into separate pieces. In the dicing step, the material to be processed which is attached to the pressure-sensitive adhesive sheet is diced according to a conventional method. When the material to be processed is the semiconductor wafer, dicing is performed usually from the circuit side of the semiconductor wafer. Such a dicing step is generally performed by rotating a blade at high speed to cut the material to be processed such as the semiconductor wafer into a specified size. Further, in this dicing step, there can be employed a cutting system called full cutting in which cuts are also made in the pressure-sensitive adhesive sheet. A dicing apparatus is not particularly limited, and can be appropriately selected from previously known apparatus for use. In the dicing step, the material to be processed such as a semiconductor wafer is effectively adhered and fixed to the pressure-sensitive adhesive sheet, so that chipping or chip scattering is inhibited or prevented, and breakage of the material to be processed itself such as the semiconductor wafer is also inhibited or prevented.

The pickup step is performed in order to separate from the pressure-sensitive adhesive sheet the cut pieces of the material to be processed which are attached to the pressure-sensitive adhesive sheet, and to pickup them. In the pickup step, pickup of the cut pieces of the material to be processed (such as semiconductor chips) in a state of being attached to the pressure-sensitive adhesive sheet is performed. In this case, a pickup method is not particularly limited, and any of various previously known pickup methods can be employed. Examples thereof include a method of pushing up respective chips with needles from the side of the pressure-sensitive adhesive sheet, and picking up the cut pieces thus pushed up with a pickup apparatus. It is important that the pickup is performed after the removable pressure-sensitive adhesive layer has been irradiated with the active energy ray. Irradiation of the active energy ray may be performed before pickup in the pickup step, or may be previously conducted prior to the pickup step. Examples of the active energy ray irradiated include $\alpha$-rays, $\beta$-rays, $\gamma$-rays, neutron beams, electron beams, and ultraviolet light, and ultraviolet light is particularly preferred. Various conditions in irradiating the active energy ray, such as irradiation intensity and irradiation time, are not particularly limited, and can be appropriately set according to the necessity.

It is important that the mounting step is performed after a wafer back grinding step. That is to say, it is important that the mounting step is usually performed continuously after a wafer back grinding step or a grinding dust layer removal step performed subsequent to the wafer back grinding step (immediately after a wafer back grinding step or a grinding dust layer removal step), or shortly after the step (within several hours after completion of the wafer back grinding step or the grinding dust layer removal step). Further, it is important that the dicing step is performed after the mounting step. For example, the dicing step may be performed successively to or shortly after the mounting step, or may be performed after the lapse of a long time from the mounting step. Furthermore, it is important that the pickup step is performed after the dicing step. For example, the pickup step may be performed successively to or shortly after the dicing step, or may be performed after the lapse of a long time from the dicing step. It is a matter of course that other steps (such as a cleaning step and an expanding step) may be performed between the mounting step and dicing step or between the dicing step and pickup step.

Examples

The invention will be illustrated in greater detail below with reference to the following examples, but the invention should not be construed as being limited thereby.

Preparation Example 1 of Ultraviolet Light Curable Acrylic Adhesive Solution

Seventy-five parts by weight of methyl acrylate, 10 parts by weight of methoxyethyl acrylate, 10 parts by weight of N-vinylpyrrolidone and 5 parts by weight of 2-hydroxyethyl acrylate were copolymerized in ethyl acetate by an ordinary method to obtain an acrylic copolymer-containing solution (sometimes referred to as acrylic copolymer solution (A)).

Then, 60 parts by weight of 2-methacryloyloxyethyl isocyanate was added to the above-mentioned acrylic copolymer-containing solution (A), and 0.1 part by weight of dibutyltin dilaurate was further added as a catalyst, followed by reacting them at 50°C for 24 hours to obtain a solution containing a double bond introduction type acrylic polymer (weight average molecular weight: 500,000) having carbon-carbon double bonds at side-chain ends (double bond introduction type acrylic polymer-containing solution (A)). This double bond introduction type acrylic polymer has a form where an isocyanate group of 2-methacryloyloxyethyl isocyanate is reacted with 90 mol% of hydroxyl groups of the side-chain ends (hydroxyl groups derived from 2-hydroxyethyl acrylate) in the acrylic copolymer by addition reaction.

Subsequently, 130 parts by weight of an ultraviolet light curable oligomer (viscosity at 25°C: 10 Pa-sec) obtained by reacting pentaerythritol triacrylate and diisocyanate with each other, 3 parts by weight of a photopolymerization initiator (trade name: "Irgacure 2959", manufactured by Ciba Specialty Chemicals Co.) and 4 parts by weight of a polyisocyanate compound (trade name: "Coronate L", manufactured by Nippon Polyurethane Industry Co., Ltd.) were added to the above-mentioned double bond introduction type acrylic polymer-containing solution (A) to prepare an ultraviolet light curable acrylic pressure-sensitive adhesive solution (sometimes referred to as pressure-sensitive adhesive solution (A)).

Preparation Example 2 of Ultraviolet Light Curable Acrylic Adhesive Solution

Seventy-five parts by weight of methyl acrylate, 10 parts by weight of methoxyethyl acrylate, 10 parts by weight of N-vinylpyrrolidone and 10 parts by weight of 2-hydroxyethyl acrylate were copolymerized in ethyl acetate by an ordinary method to obtain an acrylic copolymer-containing solution (sometimes referred to as acrylic copolymer solution (B)).

Then, 12 parts by weight of 2-methacryloyloxyethyl isocyanate was added to the above-mentioned acrylic copolymer-containing solution (B), and 0.1 part by weight of dibutyltin dilaurate was further added as a catalyst, followed by reacting them at 50°C for 24 hours to obtain a solution containing a double bond introduction type acrylic polymer (weight average molecular weight: 600,000) having carbon-carbon double bonds at side-chain ends (double bond introduction type acrylic polymer-containing solution (B)). This double bond introduction type acrylic polymer has a form where an isocyanate group of 2-methacryloyloxyethyl isocyanate is reacted with 90 mol% of hydroxyl groups of the side-chain ends (hydroxyl groups derived from 2-hydroxyethyl acrylate) in the acrylic copolymer by addition reaction.

Subsequently, 130 parts by weight of an ultraviolet light curable oligomer (viscosity at 25 °C: 10 Pa·sec) obtained by reacting pentaerythritol triacrylate and diisocyanate with each other, 3 parts by weight of a photopolymerization initiator (trade name: "Irgacure 369", manufactured by Ciba Specialty Chemicals Co.) and 4 parts by weight of a polyisocyanate compound (trade name: "Coronate L", manufactured by Nippon Polyurethane Industry Co., Ltd.) were added to the above-mentioned double bond introduction type acrylic polymer-containing solution (B) to prepare an ultraviolet light curable acrylic pressure-sensitive adhesive solution (sometimes referred to as pressure-sensitive adhesive solution (B)).

Preparation Example 3 of Ultraviolet Light Curable Acrylic Adhesive Solution

An ultraviolet light curable acrylic pressure-sensitive adhesive solution (sometimes referred to as pressure-sensitive adhesive solution (C)) was prepared in the same manner as in Preparation Example 1 of the ultraviolet light curable acrylic adhesive solution with the exception that a photopolymerization initiator (trade name: "Irgacure 651", manufactured by Ciba Specialty Chemicals Co.) was used in place of the photopolymerization initiator (trade name: "Irgacure 2959", manufactured by Ciba Specialty Chemicals Co.).

Preparation Example 4 of Ultraviolet Light Curable Acrylic Adhesive Solution

An ultraviolet light curable acrylic pressure-sensitive adhesive solution (sometimes referred to as pressure-sensitive adhesive solution (D)) was prepared in the same manner as in Preparation Example 1 of the ultraviolet light curable acrylic adhesive solution with the exception that a photopolymerization initiator (trade name: "Irgacure 369", manufactured by Ciba Specialty Chemicals Co.) was used in place of the photopolymerization initiator (trade name: "Irgacure 2959", manufactured by Ciba Specialty Chemicals Co.).

Use Example of Separator

A 38-$\mu$m thick polyester film (trade name: "Diafoil MRF38", manufactured by Mitsubishi Polyester Corporation) in which one side thereof bad been subjected to release treatment was used as a separator.

Example 1

Ultraviolet light curable acrylic pressure-sensitive adhesive solution (A) was applied to a corona-treated side of a soft polyvinyl chloride film (thickness: 70 $\mu$m, trade name: "KM Film", manufactured by Mitsubishi Chemical MKV Company) in which one side thereof had been subjected to corona treatment, in such a manner as to give a thickness of 5 $\mu$m after the formation. Then, heat treatment was conducted at 80°C for 10 minutes to perform crosslinking, thereby forming a pressure-sensitive adhesive layer on one side of the substrate. Subsequently, the above-mentioned separator was attached to the pressure-sensitive adhesive layer in a form where the release-treated surface of the separator comes into contact with a surface of the pressure-sensitive adhesive layer, thereby preparing an ultraviolet light curable pressure-sensitive adhesive sheet.

Example 2

An ultraviolet light curable pressure-sensitive adhesive sheet was prepared in the same manner as in Example 1 with the exception that ultraviolet light curable acrylic pressure-sensitive adhesive solution (B) was used in place of ultraviolet light curable acrylic pressure-sensitive adhesive solution (A).

Comparative Example 1

An ultraviolet light curable pressure-sensitive adhesive sheet was prepared in the same manner as in Example 1 with the exception that ultraviolet light curable acrylic pressure-sensitive adhesive solution (C) was used in place of ultraviolet light curable acrylic pressure-sensitive adhesive solution (A).

Comparative Example 2

An ultraviolet light curable pressure-sensitive adhesive sheet was prepared in the same manner as in Example 1 with the exception that ultraviolet light curable acrylic pressure-sensitive adhesive solution (D) was used in place of ultraviolet light curable acrylic pressure-sensitive adhesive solution (A).

Evaluation

For the pressure-sensitive adhesive sheets obtained in Examples 1 and 2 and Comparative Examples 1 and 2, pickup property, adhesion strength and dicing property were evaluated or examined by an evaluation method of pickup property, a measuring method of pressure-sensitive force and an evaluation method of dicing property which are shown below. Comprehensive evaluation was further made based on the evaluation or measurement results. The evaluation results are shown in Table 1.

In the pressure-sensitive adhesive sheets obtained in the respective Examples and Comparative Examples, one immediately after preparation of the pressure-sensitive adhesive sheet was taken as a pressure-sensitive adhesive sheet immediately after preparation, and one stored in an environment of 50°C for 1 month after preparation of the pressure-sensitive adhesive sheet was taken as a pressure-sensitive adhesive sheet after storage for 1 month. In the pressure-sensitive adhesive sheets obtained in the respective Examples and Comparative Examples, in the case that the photopolymerization initiator migrates from the pressure-sensitive adhesive sheet to the substrate, 1 month for storage in an environment of 50°C is a sufficient period of time for such migration of the photopolymerization initiator.

Evaluation Method of Pickup Property

Each of the pressure-sensitive adhesive sheets immediately after preparation and the pressure-sensitive adhesive sheets after storage for 1 month of respective Examples and Comparative Examples was mounted on a ground surface of a 6-inch silicon wafer (thickness: 100 $\mu$m) whose back side had been ground under the following back grinding conditions. The adhesive sheet was mounted in an environment with a temperature of 23°C immediately after the grinding (within 5 minutes after completion of the grinding). Then, the silicon wafer was diced under the following dicing conditions to thereby form semiconductor chips.

Subsequently, the pressure-sensitive adhesive sheet was irradiated with ultraviolet light from the back side thereof (irradiation time: 20 seconds; irradiation intensity: 500 mJ/cm$^2$). Further, 50 arbitrary semiconductor chips were picked up (separated) under the following pickup conditions, and the number of semiconductor chips successfully picked up (the number of successful pickups) was counted. The pickup property was evaluated, taking the case where all semiconductor chips were successfully picked up as "good" and the other cases as "poor".

Back Grinding Conditions

Grinder: "DFG-840" manufactured by DISCO Corporation
One axis: #600 grinding wheel (rotation speed: 4,800 rpm; down speed P1: 3.0 $\mu$m/sec; down speed P2: 2.0 $\mu$m/sec)
Two axes: #2000 grinding wheel (rotation speed, 5,500 rpm; down speed P1: 0.8 $\mu$m/sec; down speed P2: 0.6 $\mu$m/sec)

The back side of the silicon wafer was ground by 30 $\mu$m in two-axis mode, and then ground to a final silicon wafer thickness of 100 $\mu$m.

Dicing Conditions

Dicer: "DFD-651" manufactured by DISCO Corporation
Blade: "27HECC" manufactured by DISCO Corporation
Blade rotation speed: 40,000 rpm
Dicing speed: 120 mm/sec
Dicing depth: 25 $\mu$m
Cutting mode: down cutting
Dicing size: 5.0 mm $\times$ 5.0 mm

Pickup Conditions

Die bonder: "Machinery CPS-100" manufactured by NEC Corporation
Number of pins: 4
Distance between pins: 3.5 mm $\times$ 3.5 mm
Curvature of pin tip: 0.250 mm
Pin pushing-up amount: 0.50 mm
Suction holding time: 0.2 sec
Expanding amount: 3 mm

Measuring Method of Adhesion strength

Each of the pressure-sensitive adhesive sheets immediately after preparation and the pressure-sensitive adhesive sheets after storage for 1 month of respective Examples and Comparative Examples was cut into a strip form with a width of 25 mm, and attached to a mirror silicon wafer (silicon mirror wafer) [trade name: "CZN <100>2.5-3.5 (4 inches)", manufactured by Shin-Etsu Semiconductor Co., Ltd.] which had been subjected to mirror treatment in an atmosphere of 23°C (room temperature), followed by standing for 30 minutes in the atmosphere at room temperature. Thus, samples for measuring adhesion strength of the pressure-sensitive adhesive sheets immediately after preparation and the pressure-sensitive adhesive sheets after storage for 1 month of respective Examples and Comparative Examples were obtained.

For each of the samples for measuring adhesion strength of the pressure-sensitive adhesive sheets immediately after preparation and the pressure-sensitive adhesive sheets after storage for 1 month, the pressure-sensitive adhesive sheet was peeled in a temperature-controlled room at a temperature of 23°C at a pulling rate of 300 mm/min in such a direction that the angle (peel angle) θ between a surface of the pressure-sensitive adhesive layer and a surface of the mirror silicon wafer became 90°. Thus, adhesion strength before ultraviolet light irradiation was measured.

Further, the separately prepared samples for measuring adhesion strength of the pressure-sensitive adhesive sheets immediately after preparation and the pressure-sensitive adhesive sheets after storage for 1 month were irradiated with ultraviolet light (irradiation time: 20 seconds; irradiation intensity: 500 mJ/cm$^2$) from the back side of the pressure-sensitive adhesive sheet. Then, each pressure-sensitive adhesive sheet was peeled in a temperature-conrtrolled room at a temperature of 23°C at a pulling rate of 150 mm/min in a pulling direction of symbol a so that the angle (peel angle) θ between a surface of the pressure-sensitive adhesive layer and a surface of the mirror silicon wafer became 15°, as shown in Fig. 2. Thus, adhesion strength after ultraviolet light irradiation was measured.

Then, the adhesion strength before ultraviolet light irradiation was evaluated, taking the case where the value of adhesion strength (peel angle: 90°) before ultraviolet light irradiation was 1.0 N/25 mm width or more as "good" and the case where it was less than 1.0N/25 mm width as "poor". Further, the adhesion strength after ultraviolet light irradiation was evaluated, taking the case where the value of adhesion strength (peel angle: 15°) after ultraviolet light irradiation was 2.3 N/25 mm width or less as "good" and the case where it was more than 2.3 N/25 mm width as "poor".

Evaluation Method of Dicing Property

Each of the pressure-sensitive adhesive sheets immediately after preparation and the pressure-sensitive adhesive sheets after storage for 1 month of respective Examples and Comparative Examples was mounted on a ground surface of a 6-inch silicon wafer (thickness: 100 μm) whose back side had been ground under the same grinding conditions as with the case of the above-mentioned evaluation method of pickup property. The adhesive sheet was mounted in an environment at a temperature of 23°C immediately after the grinding (within 5 minutes after completion of the grinding). Then, the silicon wafer was diced to 3 mm square with a dicer "DFD-651" manufactured by DISCO Corporation, and the number of 3-mm square chips scattered after dicing was counted. The dicing property was evaluated, taking the case where all chips were not scattered as "good" and the other cases as "poor".

The blade used in dicing was "27HECC" manufactured by DISCO Corporation, the dicing speed was 80 mm/sec, and the cut amount in the pressure-sensitive adhesive sheet was 25 μm.

Comprehensive Evaluation

Comprehensive evaluation was made, taking the case where all the evaluation items concerning pickup property, adhesion strength and dicing property were "good" as "good" and the case where any one of the evaluation items was "poor" as "poor".

Table 1

| | | Example | | Comparative Example | |
|---|---|---|---|---|---|
| | | 1 | 2 | 1 | 2 |
| Pickup Property | Pressure-Sensitive Adhesive Sheet Immediately after Preparation | | | | |
| | Number of Successful Pickups | 50 | 50 | 50 | 50 |
| | Evaluation of Pickup Property | Good | Good | Good | Good |
| | Pressure-Sensitive Adhesive Sheet after Storage for 1 Month | | | | |
| | Number of Successful Pickups | 50 | 50 | 41 | 45 |
| | Evaluation of Pickup Property | Good | Good | Poor | Poor |
| Dicing Property | Pressure-Sensitive Adhesive Sheet Immediately after Preparation | | | | |
| | Number of Chips Scattered | 0 | 0 | 0 | 0 |
| | Evaluation of Dicing Property | Good | Good | Good | Good |
| | Pressure-Sensitive Adhesive Sheet after Storage for 1 Month | | | | |
| | Number of Chips Scattered | 0 | 0 | 0 | 0 |
| | Evaluation of Dicing Property | Good | Good | Good | Good |
| Adhesion strength | Pressure-Sensitive Adhesive Sheet Immediately after Preparation | | | | |
| | Measured Value of Adhesion strength before Ultraviolet Light Irradiation (90° peel) | 9.6 | 8.8 | 9.7 | 9.3 |
| | Evaluation of Pressure-Sensitive Adhesive Property | Good | Good | Good | Good |
| | Measured Value of Adhesion strength alter Ultraviolet Light Irradiation (15° peel) | 1.1 | 0.9 | 2.3 | 2.0 |
| | Evaluation of Pressure-Sensitive Adhesive Property | Good | Good | Good | Good |
| | Pressure-Sensitive Adhesive Sheet after Storage for 1 Month | | | | |
| | Measured Value of Adhesion strength before Ultraviolet Light Irradiation (90° peel) | 9.3 | 9.1 | 9.5 | 9.3 |
| | Evaluation of Pressure-Sensitive Adhesive Property | Good | Good | Good | Good |
| | Measured Value of Adhesion strength after Ultraviolet Light Irradiation (15° peel) | 1.2 | 1.0 | 4.7 | 5.0 |
| | Evaluation of Pressure-Sensitive Adhesive Property | Good | Good | Poor | Poor |
| Comprehensive Evaluation | | Good | Good | Poor | Poor |

The pressure-sensitive adhesive sheets of Examples 1 and 2 had sufficient adhesion strength before ultraviolet light irradiation, whereas the adhesion strength decreased by ultraviolet light irradiation. It was therefore confirmed that these sheets had removability.

Further, the pressure-sensitive adhesive sheets of Examples 1 and 2 enabled picking up all semiconductor chips in both cases of the pressure-sensitive adhesive sheet immediately after preparation and the pressure-sensitive adhesive sheet after storage for 1 month. It was therefore confirmed that these sheets were excellent in pickup properties.

Accordingly, the pressure-sensitive adhesive sheets of Examples 1 and 2 can be suitably used as a pressure-sensitive adhesive sheet for dicing.

On the other hand, the pressure-sensitive adhesive sheets of Comparative Examples 1 and 2 had a problem with regard to removability.

While the present invention has been described in detail and with reference to specific embodiments thereof, it will be apparent to one skilled in the art that various changes and modifications can be made therein without departing from the scope thereof.

This application is based on Japanese patent application No. 2006-328928 filed December 6, 2006, the entire contents thereof being hereby incorporated by reference.

Further, all references cited herein are incorporated in their entireties.

**Claims**

1. A removable pressure-sensitive adhesive composition comprising an acrylic polymer, a photopolymerization initiator and a crosslinking agent, wherein the acrylic polymer and the photopolymerization initiator each are chemically bonded to the crosslinking agent.

2. The removable pressure-sensitive adhesive composition according to claim 1, wherein the acrylic polymer has one carbon-carbon double bond in each of 1/100 or more of all side chains within the molecule thereof.

3. The removable pressure-sensitive adhesive composition according to claim 1, wherein the acrylic polymer has a weight average molecular weight of 500,000 or more.

4. The removable pressure-sensitive adhesive composition according to claim 1, wherein said chemical bond between the acrylic polymer and the crosslinking agent and said chemical bond between the photopolymerization initiator and the crosslinking agent each are a chemical bond between an isocyanate group and a hydroxyl group.

5. The removable pressure-sensitive adhesive composition according to claim 1, which further comprises an active energy ray-curable ingredient.

6. A pressure-sensitive adhesive tape or sheet comprising a pressure-sensitive adhesive layer formed by the removable pressure-sensitive adhesive composition according to claim 1.

7. The pressure-sensitive adhesive tape or sheet according to claim 6, which comprises a substrate and the pressure-sensitive adhesive layer disposed on at least one side of the substrate.

8. The pressure-sensitive adhesive tape or sheet according to claim 7, wherein the substrate is a soft polyvinyl chloride-based substrate.

9. The pressure-sensitive adhesive tape or sheet according to claim 6, which is for use in dicing.

10. A removable pressure-sensitive adhesive composition comprising an acrylic polymer and a photopolymerization initiator, the composition further comprising a crosslinking agent having a reactive functional group which is capable of reacting with a reactive functional group of the acrylic polymer and a reactive functional group of the photopolymerization initiator.

11. The removable pressure-sensitive adhesive composition according to claim 10, wherein the acrylic polymer has one carbon-carbon double bond in each of 1/100 or more of all side chains within the molecule thereof.

12. The removable pressure-sensitive adhesive composition according to claim 10, wherein the acrylic polymer has a weight average molecular weight of 500,000 or more.

13. The removable pressure-sensitive adhesive composition according to claim 10, wherein said chemical bond between the acrylic polymer and the crosslinking agent and said chemical bond between the photopolymerization initiator and the crosslinking agent each are a chemical bond between an isocyanate group and a hydroxyl group.

**14.** The removable pressure-sensitive adhesive composition according to claim 10, which further comprises an active energy ray-curable ingredient.

**15.** A pressure-sensitive adhesive tape or sheet comprising a pressure-sensitive adhesive layer formed by the removable pressure-sensitive adhesive composition according to claim 10.

**16.** The pressure-sensitive adhesive tape or sheet according to claim 15, which comprises a substrate and the pressure-sensitive adhesive layer disposed on at least one side of the substrate.

**17.** The pressure-sensitive adhesive tape or sheet according to claim 16, wherein the substrate is a soft polyvinyl chloride-based substrate.

**18.** The pressure-sensitive adhesive tape or sheet according to claim 15, which is for use in dicing.

## FIG. 1

## FIG. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11263946 A
- JP 2000281991 A
- JP 2006328928 A